# EUROPEAN PATENT SPECIFICATION

(11) **EP 2 075 842 B1**
(45) Date of publication and mention of the grant of the patent: **28.08.2013**
(21) Application number: 08163338.0
(22) Date of filing: 29.08.2008
(51) Int. Cl.: H01L 27/146

(54) **Semiconductor detector for electromagnetic or particle radiation**
Halbleiterdetektor für elektromagnetische Strahlung oder Teilchenstrahlung
Détecteur semiconducteur pour le rayonnement électromagnétique ou de particules

(30) Priority: 28.12.2007 GB 0725245
(43) Date of publication of application: 01.07.2009
(73) Proprietor: Cmosis NV, 2000 Antwerpen (BE)
(72) Inventor: Bogaerts, Jan, 2860, Sint Katelijne Waver (BE)
(74) Representative: Bird, Ariane

(56) References cited:
- EP-A1- 0 883 187
- EP-A2- 1 612 863
- JP-A- 11 233 747
- US-A1- 2007 052 050

## Description

### FIELD OF THE INVENTION

This invention relates to the field of semiconductor based detectors for detecting electromagnetic or particle radiation.

### BACKGROUND TO THE INVENTION

Semiconductor based sensors and devices for detecting electromagnetic radiation are known in the art. These sensors can be implemented in a semiconductor substrate (epitaxial layer, e.g. Si or SiGe) in a CMOS or MOS technology. In these sensors, the regions adapted for collecting charges generated by the electromagnetic radiation in the semiconductor substrate form pn- or np-junctions with the substrate, that is of n-type or p-type conductivity respectively. These are the collecting junctions (or photodiode junctions).

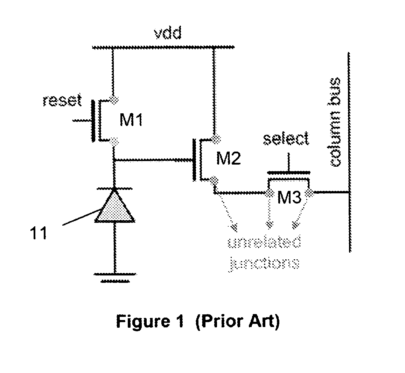

Figure 1 shows an example of a typical three transistor active pixel sensor (APS) comprising a photodiode 11 and three MOS transistors M1, M2, M3. Transistor M1 resets the photodiode capacitance, transistor M2 acts as a source-follower buffer amplifier to amplify the charge that is collected on the photodiode 11 and transistor M3 selects a particular pixel for readout, and is responsive to a row select signal.

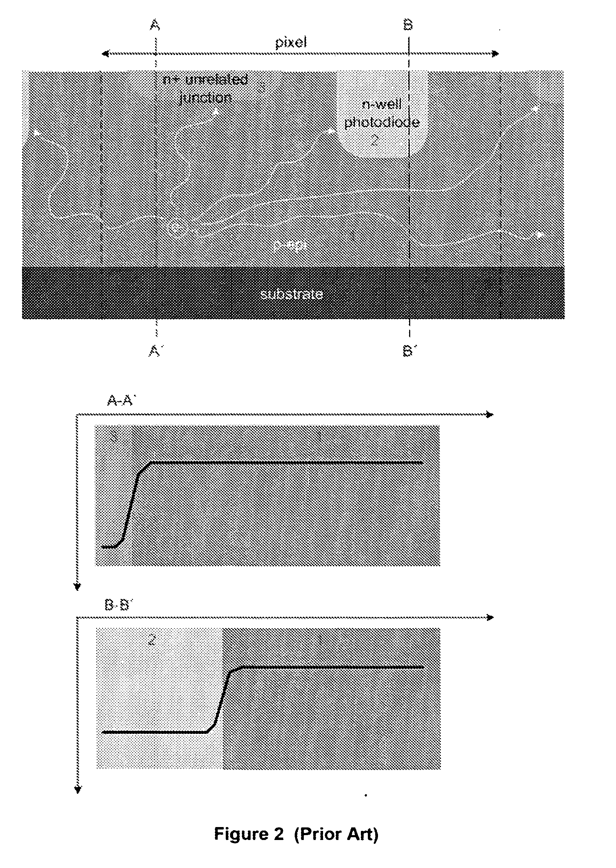

It is known that the charge-sensitive volume of a pn- or np-junction is larger than the depletion layer of the junction. All charges generated within the so-called diffusion length from the collecting junction have a chance of diffusing towards that junction and of being collected (see Figure 2). The photodiode junction can thus be of small size (e.g. few micrometers) compared to the pixel pitch since the diffusion length in present CMOS processes can be significantly larger (e.g. 100µm). However, in the case of an active pixel, if non-related electronic circuitry (junctions) are placed in the neighbourhood of the collecting photodiode, part of the charges that would otherwise reach the photodiode will be collected by these unrelated junctions. These carriers therefore will not contribute to the desired signal.

Another problem that arises where the photodiode junction is small compared to the pixel pitch is that charges that are generated within a particular pixel will not necessarily diffuse towards the photodiode of that pixel, but may diffuse and be collected by a (photo-)diode of a neighbouring pixel (within a distance equal to the diffusion length). This is because the substrate (epitaxial layer) is, in that case, nearly field-free and charges can travel freely until reaching a depletion region. This leads to reduced sharpness of the image or larger cross-talk between the pixels.

On the other hand, in many cases, the size of the photodiode is being minimised in order to minimize the capacitance of the photodiode. This photodiode capacitance determines the charge-to-voltage conversion gain of the active pixel, which should be maximised for reasons of noise performance (i.e. small photodiode capacitance). The so called kTC reset noise also decreases with decreasing photodiode capacitance. Therefore, in many cases, a trade-off needs to be made between cross-talk and photodiode capacitance.

Figure 2 shows a general cross-section of a pixel. It includes a semiconductor substrate/epitaxial layer (denoted 1) having dopants of a first conductivity type, a first region 2 and a second region 3 both having dopants of a second conductivity type. The first region (photodiode) 2 is made for collecting charges which are generated by incident radiation on the substrate. The second region 3 is an unrelated junction of the readout circuitry, such as one of the unrelated junctions shown in Figure 1. The lower part of Figure 2 shows the electrostatic potential in the detector at the indicated cross sections A-A' and B-B'. The first and second regions 2, 3, exhibit a similar electrostatic potential profile with the substrate. The disadvantage of this pixel is that a significant proportion of the generated charge carriers will be collected by the second region 3 instead of the first region 2 and that, therefore, the fill factor of the pixel is low.

Figure 3 shows a detector described in US 6,225,670. The detector has a similar structure as Figure 2 but, additionally, has a third region 5 having dopants of the first conductivity type at a higher doping density than the substrate (i.e. third region is p+ compared to p substrate). This third region 5 forms a barrier for substantially impeding the diffusion of carriers to the second region 3, while no barrier is present between the substrate and the first region 2. For pixels which require a high conversion gain, and hence a low capacitance on the photodiode, region 2 is designed to be substantially smaller than region 5. This increases the crosstalk between neighbouring pixels, and hence reduces the sharpness of the image.

A paper "High Sensitivity and No-Cross Talk Pixel Technology for Embedded CMOS Image Sensor", Furumiya et al, IEDM 00 pp.701-704, describes a pixel having a p-well layer and a deep p-well layer, with the p-well layer being broken in the region of the photodiode junction. Although the doping level of the deep p-well is lower than that of the p-well, the deep p-well layer still has a higher doping level than the epi-layer. This has a disadvantage that some charges will diffuse into the epi layer, thereby reducing the charge-collecting efficiency of the pixel.

US 2007/0069315A1 describes an image sensor having a plurality of photodetectors of a first conductivity type, a substrate of the second conductivity type, a first layer of the first conductivity type spanning the image area, a second layer of the second conductivity type, wherein the first layer is between the substrate and the second layer and the plurality of photodetectors are disposed in the second layer and abut the first layer.
US 2007/0052050 shows a backside thinned image sensor having an improved fill-factor.

The present invention seeks to provide a semiconductor detector and pixel structure for detecting radiation which has a high charge collection efficiency and ideally also has low photodiode capacitance and low cross-talk.

### SUMMARY OF THE INVENTION

A first aspect of the present invention provides a detector for particle or electromagnetic radiation as recited in claim 1.

A detector of this form can collect a very high proportion (substantially all) of the charges generated by incident radiation in the substrate/epitaxial layer of a particular pixel, with the charge-trapping region carrying the charge to the first region, which is typically the photodiode junction of that pixel, instead of allowing charge carriers to diffuse towards the photodiode of a neighbouring pixel or another unrelated junction. The detector provides maximal collection efficiency with minimal or controlled cross-talk and minimal photodiode capacitance. The photodiode junction can be made small, with a small junction capacitance. The third region does not add capacitance since it is of the other conductivity type (no charge storage in that region). Advantageously, the net doping concentration in the third region is at least two to five times lower than in the epitaxial layer.

Advantageously, the first region forms a junction with the third region, or is connected to the third region by a region having a dopant level such that collected charge carriers will be guided towards the first region.

In one exemplary embodiment, not making part of the present invention, the third region forms a continuous layer across the detector beneath the first and second regions and the third region is separated from another third region, which is associated with another first region. This separation ensures that the charge-trapping function of the third region acts on a well-defined part of the detector, and prevents charges leaking towards neighbouring first regions. A gap between neighbouring third regions can include at least one isolating structure to further isolate the third region from a neighbouring third region. Advantageously, the isolating structure extends in a direction substantially perpendicular to the plane of the substrate/epitaxial layer. The isolating structure can be formed with dopants of the first conductivity type at a high level, or as an etched trench.

In the present invention, the third region is a continuous layer across the detector.

Advantageously, the detector further comprises a fourth region, positioned between the third region and the second region, having net dopants of the first conductivity type at a higher doping level than the third region. The second region and fourth region can comprise a semiconductor junction which can be operated independently of the first region. Advantageously, the doping concentration in the fourth region is at least two to five times higher than in the third region.

Advantageously, the detector can be used in thinned photodetectors which are to be exposed to radiation on a side of the substrate remote from the first and second regions. This is typically called backside illumination, with the 'front side' being the side on which the first and second regions are provided. Backside illuminated detectors are used to increase sensitivity. The wafer containing the image sensor or array of detectors is thinned, the backside is covered by an anti-reflective coating, and the device is illuminated from the backside. The entire area of the backside is comprised of semiconductor material and there is no metal routing on top which, if present, would reduce the light sensitive portion of the surface. Conventionally, backside illuminated detectors can suffer from a problem when the photodetector is located close to the front side, in that charge carriers generated by incoming radiation can diffuse to neighbouring pixels, leading to an undesirably high level of cross-talk. With a detector of the form as described in the present invention, the detector can be located close to the front side, and the charge-trapping region ensures that there is less chance for the charge carriers to diffuse to neighbouring pixels before they are trapped by the detector. Accordingly, cross-talk between pixels is reduced, which improves the sharpness of the image for a backside illuminated sensor.

The detector can be used as a pixel of an image sensor, there being a plurality of such pixels provided on the substrate/epitaxial layer which forms the image sensor.

A further aspect of the present invention provides an image sensor comprising an array of pixels, with each pixel comprising a detector of the above form.

A further aspect of the present invention provides a method of manufacturing a detector for particle or electromagnetic radiation as recited in claim 11.

The various regions of the detector structure are processed inside the epitaxial layer on top of a bulk substrate. The bulk substrate can be silicon or any other material, like silicon oxide. The bulk substrate can be thinned (removed) after processing to form a thinned image sensor. The various regions can be formed: by diffusion or ion implantation and annealing processing steps on an epitaxial starting wafer; during epitaxial growth; or a combination of both techniques.

### BRIEF DESCRIPTION OF THE DRAWINGS

Embodiments of the invention will be described, by way of example only, with reference to the accompanying drawings in which:
Figure 1 schematically shows a known active pixel sensor (APS);
Figure 2 shows a known semiconductor detector and electrostatic field profiles;
Figure 3 shows another known semiconductor detector and electrostatic field profiles;
Figure 4 shows a semiconductor detector in accordance with an exemplary embodiment not making part of the present invention with a p- doped charge-collecting region, and electrostatic field profiles for cross-sections through the detector;
Figures 5 and 6 show how a region above the new charge-collecting region can be independently operated;
Figures 7 to 9 show the detector of the present invention with a continuous charge-collecting region;
Figure 10 shows doping levels in the detector structure;
Figures 11 and 12 show doping levels in the detector structure show the use of isolating trenches between charge-collecting regions;
Figure 13 shows a detector with backside illumination;
Figure 14 shows an alternative embodiment using an n-type substrate.

### DESCRIPTION OF PREFERRED EMBODIMENTS

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Furthermore, the terms first, second, third and the like in the description and in the claims, are used for distinguishing between similar elements and not necessarily for describing a sequential or chronological order.

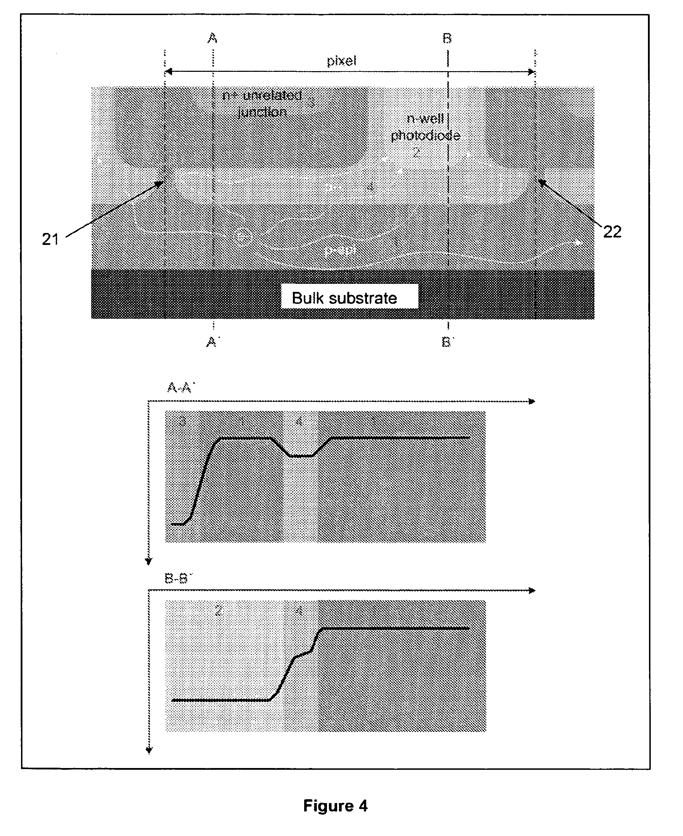

An exemplary embodiment not making part of the present invention is shown in Figure 4. The detector includes a semiconductor substrate/epitaxial layer 1 having dopants of a first conductivity type, a first region 2 and a second region 3 both having dopants of a second conductivity type. In this example, first region 2 is an n-well photodiode and second region 3 is an n+ unrelated junction, such as a junction of one of the neighbouring devices of the active pixel, shown in Figure 1. The substrate further comprises a third region 4. In Figure 4, the third region 4 has net dopants of the first conductivity type at a lower doping density than the substrate/epitaxial layer 1. The third region 4 serves, in use, as a trap for charges generated within the substrate/epitaxial layer 1 when diffusing towards unrelated junctions. An advantage of this pixel is that the diffusing charges in the substrate/epitaxial layer can rapidly be trapped within this third region 4. Once trapped within the third region 4, charges will be guided to the photodiode 2 and will not further diffuse in the substrate/epitaxial layer 1 towards neighbouring pixels. Referring to the electrostatic field profiles of Figures 4, it can be seen that in the region of the unrelated junction A-A', the third region 4 is at a higher potential than the neighbouring regions of the substrate. Accordingly, once charge has reached region 4, charge is unlikely to diffuse from the third region 4 to the substrate/epitaxial layer material 1 positioned above and below region 4. Along the cross-section B-B', it can be seen that the substrate/epitaxial layer 1 beneath region 4 is at a lower potential than region 4. This encourages charge to diffuse towards region 4. Similarly, region 2 of the n-well photodiode is at a higher potential than region 4, and this causes charge to diffuse from region 4 towards region 2. When describing the electrostatic potential profiles, the terms "high potential" and "low potential" refer to potentials with respect to electrons. It will be appreciated that the potentials are reversed when considering charge carriers of the opposite polarity.

The third region 4 does not add additional capacitance to the photodiode. In fact, it can even lower the capacitance, and can achieve minimal cross-talk between pixels. The cross-talk between pixels can be controlled by the shape of the third region 4 while the first collecting region 2 can be minimised in size, or have its capacitance controlled, without compromising the cross-talk. The most optimal case is when the third region 4 is as large as possible, with small gaps in between such regions 4. However, it could be economically more advantageous to re-use a mask from another processing step that is suboptimal. In some applications, very specific shapes could be used (e.g. when more than one photodiode is made in the pixel).

In Figure 4 the charge-collecting region 4 extends, in a lateral (left-to-right) direction, each side of the n-well photodiode. The width of the pixel is defined by the width of the charge-collecting region 4. In these examples the charge-collecting third region 4 is discontinuous, with gaps 21, 22 separating region 4 from neighbouring regions 4.

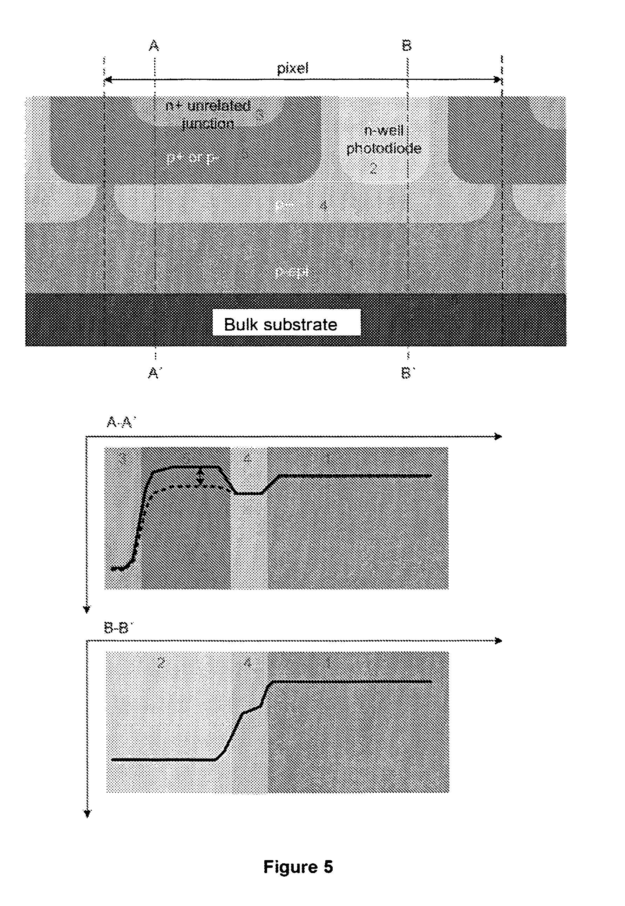

Figure 5 shows a pixel structure according to a further exemplary embodiment not making part of the invention. Compared to the pixel of Figures 4, Figure 5 has a fourth region 5 having dopants of the first conductivity type with a doping level that is higher than that of the third region 4, but lower or higher than that of the substrate/epitaxial layer 1. The electrostatic field profile along cross-section A-A' demonstrates that the doping level of the fourth region 5 can be adapted such that threshold voltages, or junction capacitances, of the unrelated junctions 3 (or the MOS devices of which the unrelated junctions 3 are part of) can be controlled in a wide range for an optimal operation performance of the readout circuitry, while not affecting the trapping function of the third region 4. It can be seen that a wide range of variation is possible to region 5, while still allowing region 4 to be at a higher potential, and therefore continue to trap and guide charge towards photodiode 2. The level of region 5 can be determined during manufacture of the detector, by selective doping concentration resulting in different built-in potentials. Doping level of the fourth region itself can also be important for MOS threshold voltage adjustment. Alternatively, the level of region 5 can be set by applying an external bias voltage. The combination of region 4 and region 5 forms a p-n junction which can be used as part of a device, such as a transistor or capacitor. The threshold voltage of a transistor depends on the doping level of region 5. Normally, the doping level of region 5 is adjusted to achieve the desired threshold voltage level. This optimisation can still be achieved with this invention, without disturbing the charge collection efficiency of the photodiode 2.

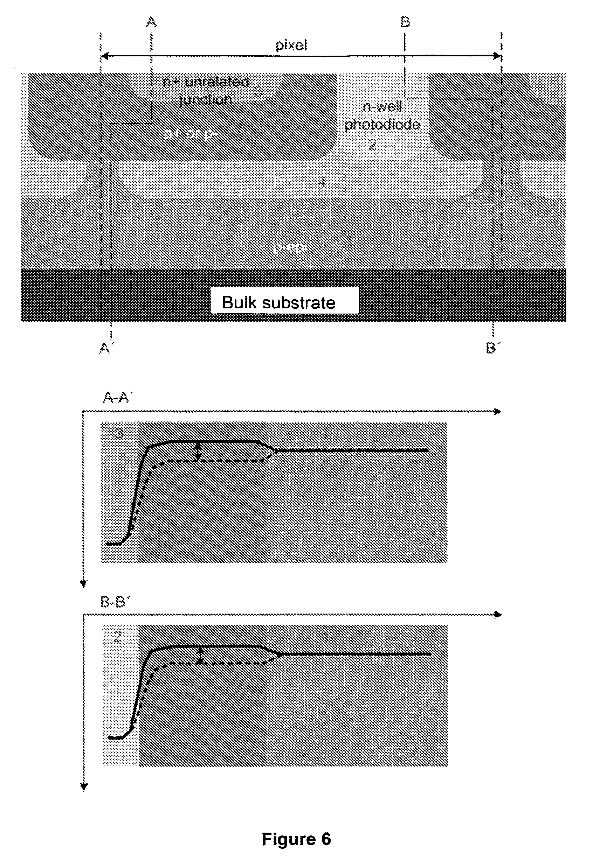

Figure 6 shows the same pixel structure as Figure 5. Plots of electrostatic potential are shown along paths A-A' and B-B'. These cross-sections pass through the fourth region 5 and the substrate/epitaxial layer 1. Two options for the region 5 are illustrated. In a first option, region 5 has a potential below that of region 4 and above that of the p-epi layer 1. This will cause charge to always diffuse towards charge-trapping region 4. Even in the discontinuities between neighbouring regions 4, the interface between the p-epi layer 1 and region 5 (shown in the potential profile of Figure 6) has the p-epi layer 1 at a higher potential than the region 5, and so charge will not be attracted towards region 5, and on to unrelated junction 3. In a second option, shown as a dashed line in Figures 5 and 6, region 5 has a lower potential than region 4, but a higher potential than region 1. In most of the pixel area, charges generated in the p-epi layer 1 will first encounter the charge-trapping region 4 and will be guided towards the photodiode 2. In the discontinuities between regions 4, there is a possibility that charges can leak from region 1 into region 5. However, in reality, the discontinuities in region 4 will typically be small and charges moving vertically (upwards in the drawing) will, when entering the small discontinuity, feel the attracting influence of regions 4, which are at a higher potential than region 1 or region 5. It should be remembered that the (lateral) influence of regions 4 can be felt at a certain distance from the region, depending on doping levels. At that point, charges will move in a lateral direction (left/right in the drawing) towards one of the regions 4. In the unlikely case that they escape collection by one of the regions 4, the charges can either move into region 5 and towards the unrelated junctions 3 (unwanted) or eventually go to regions 4 and the photodiode. In practice, in a well-engineered process and design, the chance of charges moving to the unrelated junctions can be made very small.

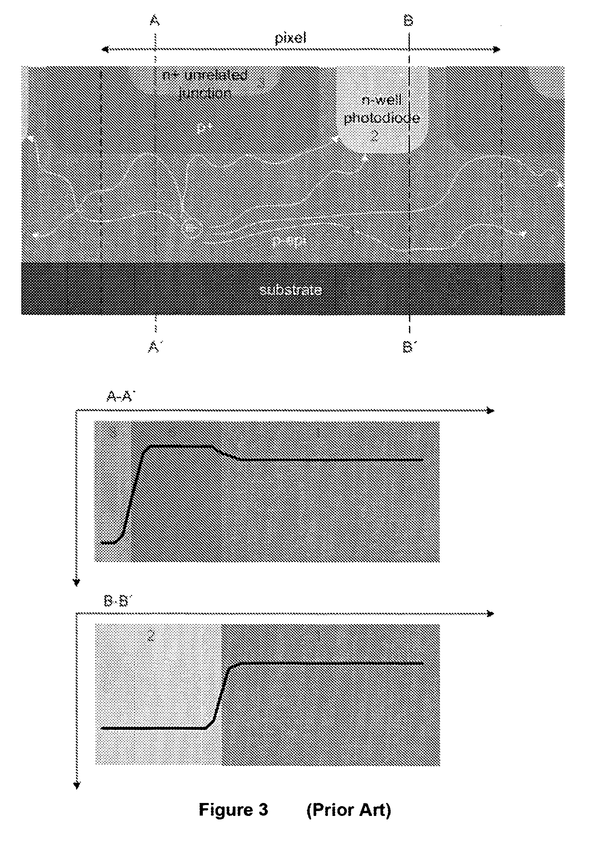

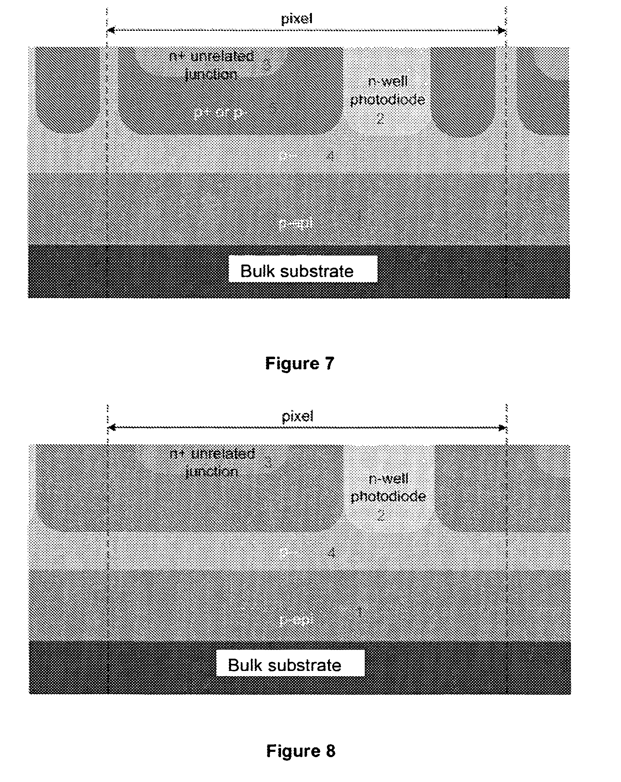

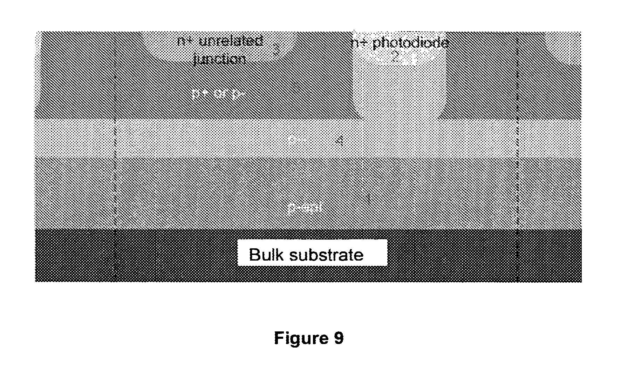

Figures 7-9 show embodiments of the present invention. In the present invention the third region 4 of different pixels forms a single, continuous band across the device. This will be less effective in reducing cross-talk. However, charges that are caught in this region 4 will only diffuse substantially in lateral direction and therefore will less easily escape collection by the photodiode. The continuous layer 4 can be manufactured by implantation without using a mask (blank implant), which is cheaper than implantation using a mask aligned with particular regions of the wafer. There is still an advantage in terms of cross-talk behaviour compared to Figure 3 since charges that are caught ('trapped') in region 4 cannot really diffuse in the up/down direction. In Figure 7 an n-well photodiode 2 extends to the top of region 4. Region 5 is doped p+/p-, i.e. having dopants of the first conductivity type with a doping level that is lower than that of the third region 4, but higher or lower than that of the substrate/epitaxial layer 1. In Figure 8 an n-well photodiode 2 extends to the top of region 4 and no dopants are added to the substrate between region 4 and region 3. In Figure 9, an n+ photodiode is implanted at the surface of the device and a channel having the same dopant level as region 4 extends between region 4 and the photodiode 2.

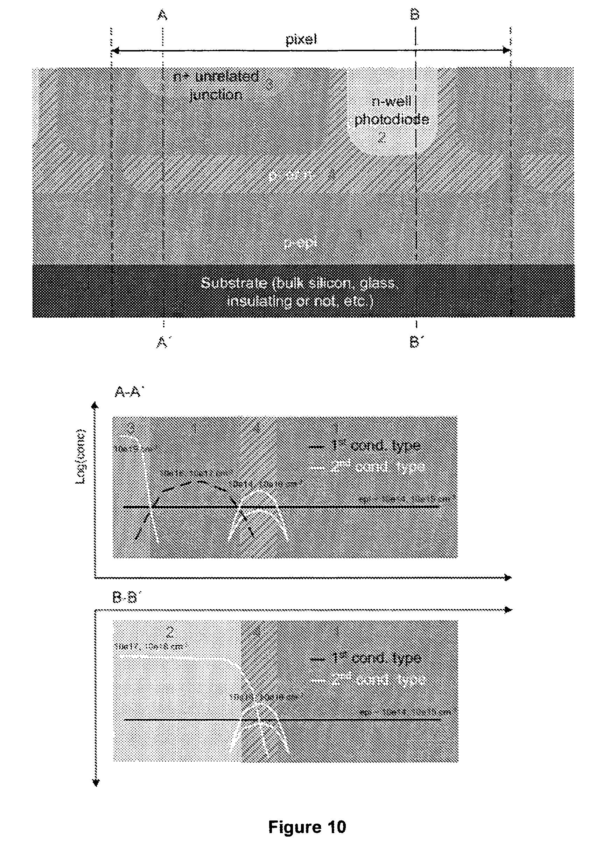

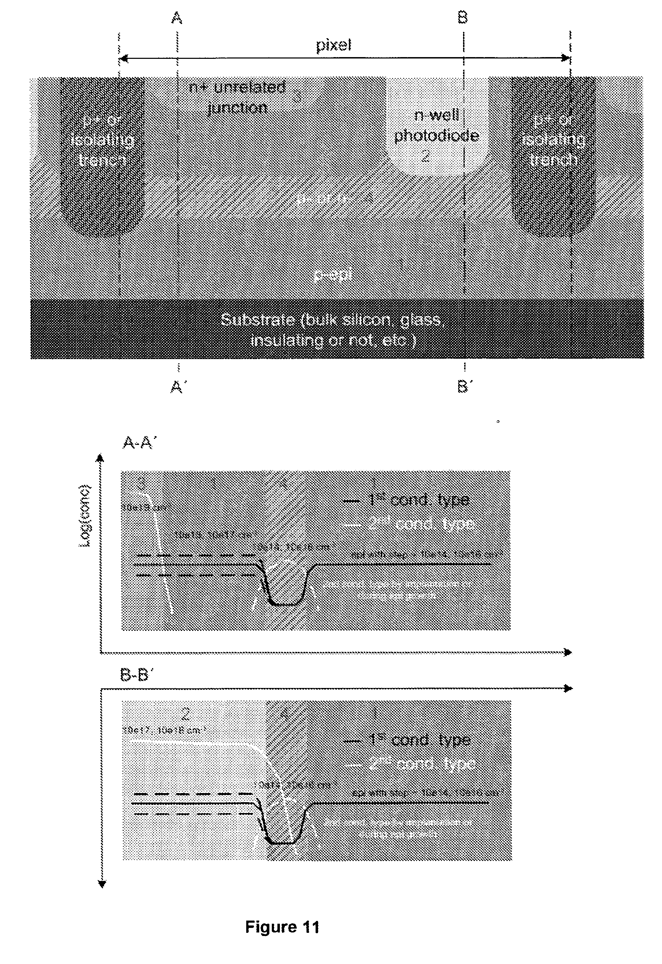

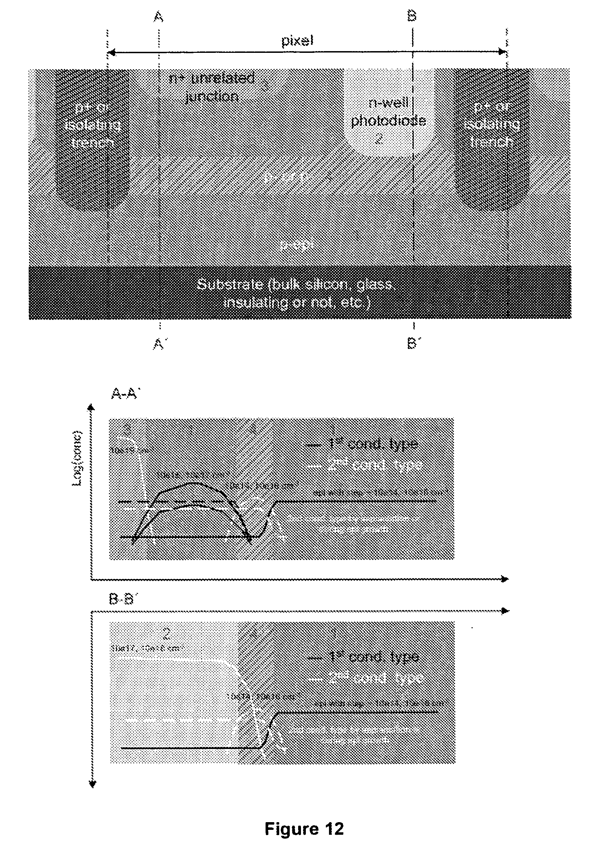

Figures 10 to 12 show examples of the doping levels used in the pixel structures, along cross-sections A-A' and B-B' through the device. Figure 10 shows the case where the regions are formed by typical diffusion or ion implantation and annealing processing steps on the epitaxial starting wafer. Figure 11 shows a similar structure showing that the different regions can also be defined during epitaxial growth. Figure 12 gives an example of a combination of both.

Figures 11 and 12 show a further feature of the pixel structure. An isolating trench extends into the substrate, from the surface down to below the level of the charge-collecting region 4. The isolating trench can be formed by heavy doping. The isolating trench forms a barrier to eliminate any cross-talk due to diffusion in region 4 and is especially useful if the charge-collecting region 4 is formed as a continuous band across the wafer. The end result and performance is similar as in Figures 4-6, but implementation is different in terms of relative doping levels of the different regions (darkly-shaded regions should be understood to have higher doping levels). As an alternative to heavy levels of doping, the isolating structure can be formed as an etched trench into the substrate.

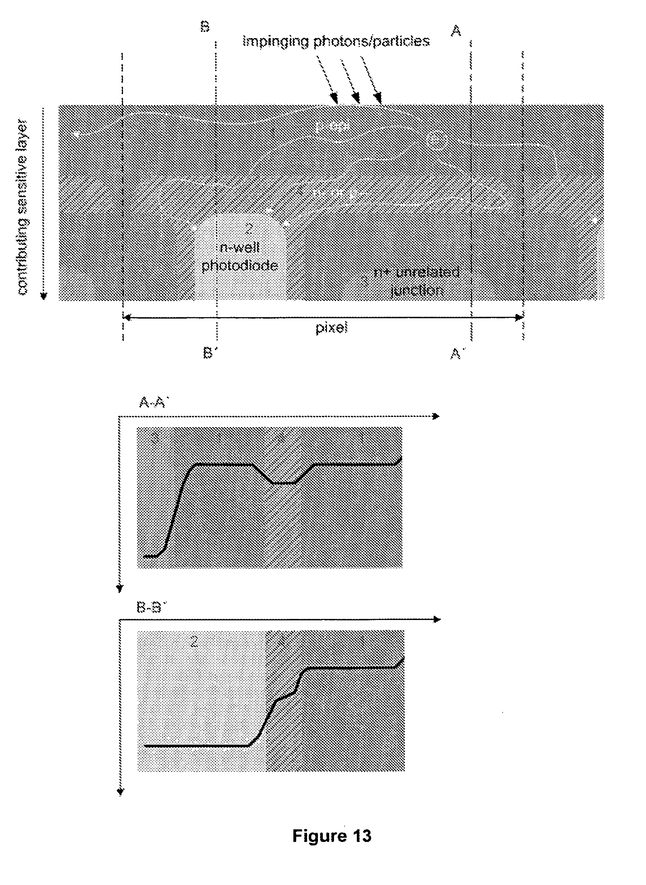

The structure described above is typically processed inside an epitaxial layer on top of a bulk substrate, as shown in Figures 4-12. This bulk substrate can be silicon or any other material, like silicon oxide. The method can also be used with thinned image sensors, which are thinned after processing to remove the bulk substrate. In use, these thinned sensors are exposed to radiation on a side of the substrate remote from the first and second regions in order to increase sensitivity. This is typically called backside illumination. Figure 13 shows a backside illuminated sensor. After manufacture, the bulk substrate is not present.

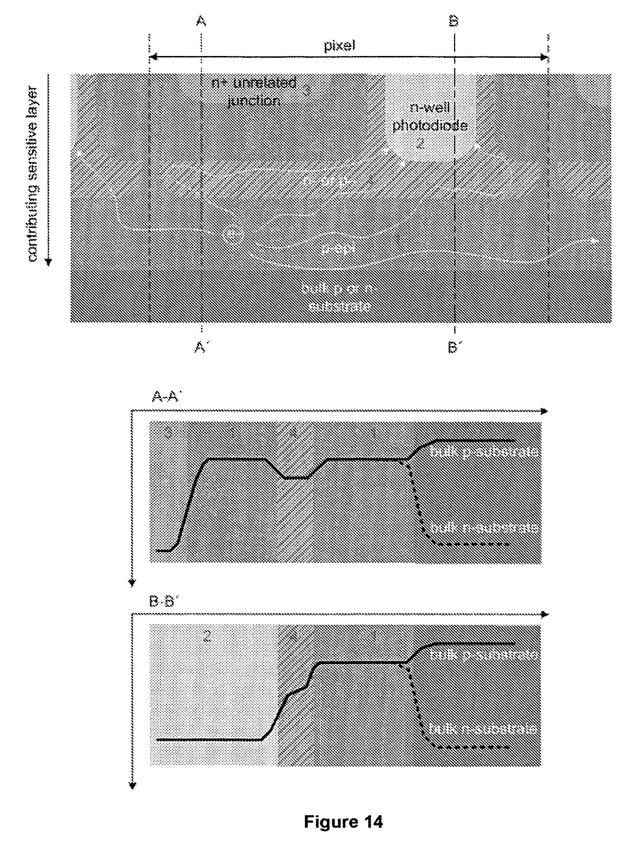

Figure 14 shows an embodiment of the detector with an n-type substrate and illustrates, in the electrostatic potential profiles, the differences between an n-type and n-type substrate. In the case of an n-substrate, the p-epi/n-substrate junction competes with the photodiode 2 for collecting charges. This will create a kind of cut-off for longer wavelengths which are, on average, absorbed more deeply into the substrate. This is unlikely to be a problem for many applications, and has an advantage of reducing cross-talk from longer wavelengths.

The detector can be used in both passive and active CMOS pixels and, in principle, it is also applicable to CCD and/or combined CMOS/CCD processes. In case of a CCD, the unrelated junctions 3 shown in the Figures are other potential wells induced by other (clocked) gates instead of pn-junctions.

The invention is not limited to the embodiments described herein, which may be modified or varied without departing from the scope of the invention.

## Claims

1. A semiconductor detector for particle or electromagnetic radiation comprising:
- a substrate;
- an epitaxial layer (1) having dopants of a first conductivity type, provided on said substrate;
- a first region (2) and a second region (3), provided in said epitaxial layer (1), both having net dopants of a second conductivity type, the first region (2) being adapted for collecting charge carriers generated in the epitaxial layer (1) by the radiation and the second region forming part of another junction of the detector; **characterized in that** said semiconductor detector further comprises
- a third region (4) having net dopants of the first conductivity type at a lower doping level than the epitaxial layer; wherein the third region (4) is positioned beneath the first (2) and second regions (3) and forms a charge-trapping region for collecting charge carriers generated in the epitaxial layer (1) and for channelling them towards the first region (2) and wherein the third region (4) is a continuous layer across the detector and adjoins another third region (4), which is associated with another first region (2) of neighbouring regions.

2. A detector according to claim 1 wherein the first region (2) forms a junction with the third region (4), or is connected to the third region (4) by a region having a dopant level such that collected charge carriers will be guided towards the first region (2).

3. A detector according to anyone of the preceding claims wherein the first region (2) is a well diode.

4. A detector according to anyone of the preceding claims wherein the first region (2) is a photodiode junction.

5. A detector according to anyone of the preceding claims further comprising a fourth region (5), positioned between the third region (4) and the second region (3), having net dopants of the first conductivity type at a higher doping level than the third region (4).

6. A detector according to claim 5 wherein the second region (3) and fourth region (5) comprise a semiconductor junction which can be operated independently of the first region (2).

7. A detector according to anyone of the preceding claims formed in a CMOS technology.

8. A detector according to anyone of the preceding claims which is adapted to be exposed to radiation on a side of the detector remote from the first (2) and second regions (3).

9. A detector according to claim 1 wherein the substrate is of the first conductivity type.

10. An image sensor comprising an array of pixels, each pixel comprising a detector of the form according to anyone of the preceding claims and a readout circuit.

11. A method of manufacturing a semiconductor detector for particle or electromagnetic radiation comprising:
- forming an epitaxial layer (1) having dopants of a first conductivity type on a substrate;
- forming a first region (2) and a second region (3), in said epitaxial layer (1), both having net dopants of a second conductivity type, the first region (2) being adapted for collecting charge carriers generated in the epitaxial layer (1) by the radiation and the second region (3) forming part of another junction of the detector; **characterized in that** said method further comprises
- forming a third region (4) having net dopants of the first conductivity type at a lower doping level than the epitaxial layer (1); wherein the third region (4) is positioned beneath the first (2) and second regions (3) and forms a charge-trapping region for collecting charge carriers generated in the epitaxial layer (1) and for channelling them towards the first region (2) and wherein the third region (4) is a continuous layer across the detector and adjoins another third region (4), which is associated with another first region (2) of neighbouring regions.

## Patentansprüche

1. Halbleiterdetektor für Partikel- oder elektromagnetische Strahlung, umfassend:
- ein Substrat;
- eine Epitaxialschicht (1) mit Dotierungsmittel eines ersten Leitfähigkeitstyps, die auf dem Substrat vorgesehen ist;
- eine erste Region (2) und eine zweite Region (3), die in der Epitaxialschicht (1) vorgesehen sind, die beide effektive Dotierungsmittel eines zweiten Leitfähigkeitstyps haben, wobei die erste Region (2) zum Sammeln von Ladungsträgern ausgebildet ist, die in der Epitaxialschicht (1) durch die Strahlung erzeugt werden, und die zweite Region Teil eines anderen Übergangs des Detektors bildet; **dadurch gekennzeichnet, dass** der Halbleiterdetektor des Weiteren umfasst
- eine dritte Region (4) mit effektiven Dotierungsmitteln des ersten Leitfähigkeitstyps bei einem geringen Dotierungswert als die Epitaxialschicht; wobei die dritte Region (4) unterhalb der ersten (2) und zweiten Region (3) positioniert ist und eine Ladungsfangregion zum Sammeln von Ladungsträgern bildet, die in der Epitaxialschicht (1) erzeugt werden, und zum Kanalisieren derselben zu der ersten Region (2), und wobei die dritte Region (4) eine kontinuierliche Schicht über den Detektor ist und an eine weitere dritte Region (4) angrenzt, die mit einer weiteren ersten Region (2) benachbarter Regionen verbunden ist.

2. Detektor nach Anspruch 1, wobei die erste Region (2) einen Übergang mit der dritten Region (4) bildet oder mit der dritten Region (4) durch eine Region verbunden ist, die einen derartigen Dotierungswert hat, dass gesammelte Ladungsträger zur ersten Region (2) geleitet werden.

3. Detektor nach einem der vorangehenden Ansprüche, wobei die erste Region (2) eine Well-Diode ist.

4. Detektor nach einem der vorangehenden Ansprüche, wobei die erste Region (2) ein Photodiodenübergang ist.

5. Detektor nach einem der vorangehenden Ansprüche, des Weiteren umfassend eine vierte Region (5), die zwischen der dritten Region (4) und der zweiten Region (3) angeordnet ist, mit effektiven Dotierungsmitteln des ersten Leitfähigkeitstyps bei einem höheren Dotierwert als die dritte Region (4).

6. Detektor nach Anspruch 5, wobei die zweite Region (3) und vierte Region (5) einen Halbleiterübergang umfassen, der unabhängig von der ersten Region (2) betrieben werden kann.

7. Detektor nach einem der vorangehenden Ansprüche, der in einer CMOS-Technologie gebildet ist.

8. Detektor nach einem der vorangehenden Ansprüche, der dazu ausgebildet ist, einer Strahlung an einer Seite des Detektors ausgesetzt zu werden, die der ersten (2) und zweiten (3) fern ist.

9. Detektor nach Anspruch 1, wobei das Substrat vom ersten Leitfähigkeitstyp ist.

10. Bildsensor, umfassend ein Array von Pixeln, wobei jedes Pixel einen Detektor der Form nach einem der vorangehenden Ansprüche und eine Ausleseschaltung umfasst.

11. Verfahren zur Herstellung eines Halbleiterdetektors für Partikel- oder elektromagnetische Strahlung, umfassend:
- Bilden einer Epitaxialschicht (1) mit Dotierungsmittel eines ersten Leitfähigkeitstyps auf einem Substrat;
- Bilden einer ersten Region (2) und einer zweiten Region (3) in der Epitaxialschicht (1), die beide effektive Dotierungsmittel eines zweiten Leitfähigkeitstyps haben, wobei die erste Region (2) zum Sammeln von Ladungsträgern ausgebildet ist, die in der Epitaxialschicht (1) durch die Strahlung erzeugt werden, und die zweite Region (3) Teil eines anderen Übergangs des Detektors bildet; **dadurch gekennzeichnet, dass** das Verfahren des Weiteren umfasst
- Bilden einer dritten Region (4) mit effektiven Dotierungsmitteln des ersten Leitfähigkeitstyps bei einem geringen Dotierungswert als die Epitaxialschicht; wobei die dritte Region (4) unterhalb der ersten (2) und zweiten Region (3) positioniert ist und eine Ladungsfangregion zum Sammeln von Ladungsträgern bildet, die in der Epitaxialschicht (1) erzeugt werden, und zum Kanalisieren derselben zu der ersten Region (2), und wobei die dritte Region (4) eine kontinuierliche Schicht über den Detektor ist und an eine weitere dritte Region (4) angrenzt, die mit einer weiteren ersten Region (2) benachbarter Regionen verbunden ist.

## Revendications

1. Détecteur à semi-conducteur pour rayonnement particulaire ou électromagnétique comprenant :
- un substrat ;
- une couche épitaxiale (1) ayant des impuretés d'un premier type de conductivité, disposée sur ledit substrat ;
- une première région (2) et une deuxième région (3) disposées dans ladite couche épitaxiale (1), toutes deux ayant des impuretés nettes d'un second type de conductivité, la première région (2) étant conçue pour recueillir des porteurs de charge produits dans la couche épitaxiale (1) par le rayonnement et la seconde région formant une partie d'une autre jonction du détecteur ; **caractérisé en ce que** ledit détecteur à semi-conducteur comprend en outre
- une troisième région (4) ayant des impuretés nettes du premier type de conductivité à un niveau de dopage inférieur à la couche épitaxiale ; dans lequel la troisième région (4) est positionnée au-dessous de la première (2) et de la deuxième région (3) et forme une région de capture de charge pour capturer des porteurs de charge produits dans la couche épitaxiale (1) et pour les canaliser vers la première région (2) et dans lequel la troisième région (4) est une couche continue d'un bout à l'autre du détecteur et est contiguë à une autre troisième région (4), qui est associée à une autre première région (2) de régions voisines.

2. Détecteur selon la revendication 1 dans lequel la première région (2) forme une jonction avec la troisième région (4), ou est reliée à la troisième région (4) par une région ayant un niveau d'impuretés tel que des porteurs de charge recueillis seront guidés vers la première région (2).

3. Détecteur selon l'une quelconque des revendications précédentes dans lequel la première région (2) est une diode à puits.

4. Détecteur selon l'une quelconque des revendications précédentes dans lequel la première région (2) est une jonction de photodiode.

5. Détecteur selon l'une quelconque des revendications précédentes comprenant en outre une quatrième région (5), positionnée entre la troisième région (4) et la deuxième région (3), ayant des impuretés nettes du premier type de conductivité à un niveau de dopage plus élevé que la troisième région (4).

6. Détecteur selon la revendication 5, dans lequel la deuxième région (3) et la quatrième région (5) comprennent une jonction à semi-conducteur qui peut être mise en oeuvre indépendamment de la première région (2).

7. Détecteur selon l'une quelconque des revendications précédentes, formé dans une technologie CMOS.

8. Détecteur selon l'une quelconque des revendications précédentes, qui est conçu pour être exposé au rayonnement sur un côté du détecteur distant de la première (2) et de la deuxième région (3).

9. Détecteur selon la revendication 1, dans lequel le substrat est du premier type de conductivité.

10. Capteur d'image comprenant un groupement de pixels, chaque pixel comprenant un détecteur de la forme selon l'une quelconque des revendications précédentes et un circuit de lecture.

11. Procédé de fabrication d'un détecteur à semi-conducteur pour rayonnement particulaire ou électromagnétique comprenant :
- la formation d'une couche épitaxiale (1) ayant des impuretés d'un premier type de conductivité sur un substrat ;
- la formation d'une première région (2) et d'une deuxième région (3) dans ladite couche épitaxiale (1), toutes deux ayant des impuretés nettes d'un second type de conductivité, la première région (2) étant conçue pour recueillir des porteurs de charge produits dans la couche épitaxiale (1) par le rayonnement et la deuxième région (3) formant une partie d'une autre jonction du détecteur ; **caractérisé en ce que** ledit procédé comprend en outre
- la formation d'une troisième région (4) ayant des impuretés nettes du premier type de conductivité à un niveau de dopage inférieur à la couche épitaxiale (1) ; dans lequel la troisième région (4) est positionnée au-dessous de la première (2) et de la deuxième région (3) et forme une région de capture de charge pour recueillir des porteurs de charge produits dans la couche épitaxiale (1) et pour les canaliser vers la première région (2) et dans lequel la troisième région (4) est une couche continue d'un bout à l'autre du détecteur et est contiguë à une autre troisième région (4), qui est associée à une autre première régions (2) de régions voisines.
